# EUROPÄISCHE PATENTSCHRIFT

(11) **EP 1 274 648 B1**
(45) Veröffentlichungstag und Bekanntmachung des Hinweises auf die Patenterteilung: **18.08.2004**
(21) Anmeldenummer: 01919184.0
(22) Anmeldetag: 10.03.2001
(51) Int. Cl.: B81C 1/00, B81B 3/00

(54) **MIKROMECHANISCHES BAUELEMENT UND ENTSPRECHENDES HERSTELLUNGSVERFAHREN**
MICROMECHANICAL COMPONENT AND METHOD FOR PRODUCING THE SAME
COMPOSANT MICROMECANIQUE ET SON PROCEDE DE PRODUCTION

(30) Priorität: 07.04.2000 DE 10017422
(43) Veröffentlichungstag der Anmeldung: 15.01.2003
(73) Patentinhaber: ROBERT BOSCH GMBH, 70442 Stuttgart (DE)
(72) Erfinder: LUTZ, Markus, Sunnyvale, CA 94086 (US)
(86) Internationale Anmeldenummer: PCT/DE2001/000921
(87) Internationale Veröffentlichungsnummer: WO 2001/077009

(56) Entgegenhaltungen:
- EP-A- 0 001 038
- DE-A- 19 509 868
- DE-A- 19 537 814
- US-A- 4 665 610
- LIU C ET AL: "SEALING OF MICROMACHINED CAVITIES USING CHEMICAL VAPOR DEPOSITION METHODS: CHARACTERIZATION AND OPTIMIZATION" JOURNAL OF MICROELECTROMECHANICAL SYSTEMS,IEEE INC. NEW YORK,US, Bd. 8, Nr. 2, Juni 1999 (1999-06), Seiten 135-145, XP000912714 ISSN: 1057-7157
- NING Y B ET AL: "Fabrication of a silicon micromachined capacitive microphone using a dry-etch process" SENSORS AND ACTUATORS A,CH,ELSEVIER SEQUOIA S.A., LAUSANNE, Bd. 53, Nr. 1, 1. Mai 1996 (1996-05-01), Seiten 237-242, XP004018152 ISSN: 0924-4247
- PARTRIDGE A ET AL: "New thin film epitaxial polysilicon encapsulation for piezoresistive accelerometers" TECHNICAL DIGEST. MEMS 2001. 14TH IEEE INTERNATIONAL CONFERENCE ON MICRO ELECTRO MECHANICAL SYSTEMS (CAT. NO.01CH37090), TECHNICAL DIGEST. MEMS 2001. 14TH IEEE INTERNATIONAL CONFERENCE ON MEMS, INTERLAKEN, CH, 21-25 JANUARY 2001, 21. - 25. Januar 2001, Seiten 54-59, XP002169905 2001, Piscataway, NJ, USA, IEEE, USA ISBN: 0-7803-5998-4

## Beschreibung

### STAND DER TECHNIK

Die vorliegende Erfindung betrifft ein mikromechanisches Bauelement mit einem Substrat und einer beweglichen Sensorstruktur in einer ersten mikromechanischen Funktionsschicht auf der Opferschicht. Die Erfindung betrifft ebenfalls ein entsprechendes Herstellungsverfahren.

Obwohl auf beliebige mikromechanische Bauelemente und Strukturen, insbesondere Sensoren und Aktuatoren, anwendbar, werden die vorliegende Erfindung sowie die ihr zugrundeliegende Problematik in bezug auf ein in der Technologie der Silizium-Oberflächenmikromechanik herstellbares mikromechanisches Bauelement, z.B. einen Beschleunigungssensor, erläutert.

Allgemein bekannt sind monolithisch integrierte inertiale Sensoren in Oberflächenmikromechanik (OMM), bei denen die empfindlichen beweglichen Strukturen ungeschützt auf dem Chip aufgebracht sind (Analog Devices). Dadurch entsteht ein erhöhter Aufwand beim Handling und bei der Verpackung.

Umgehen kann man dieses Problem durch einen Sensor, wobei die OMM-Strukturen mittels einem zweiten Kappenwafer abgedeckt sind. Diese Art der Verpackung verursacht einen hohen Anteil (ca. 75%) der Kosten eines OMM-Beschleunigungssensors. Diese Kosten entstehen durch den hohen Flächenbedarf der Dichtfläche zwischen Kappenwafer und Sensorwafer und aufgrund der aufwendigen Strukturierung (2-3 Masken, Bulkmikromechanik) des Kappenwafers.

In der DE 195 37 814 A1 werden der Aufbau eines funktionalen Schichtsystems und ein Verfahren zur hermetischen Verkappung von Sensoren in Oberflächenmikromechanik beschrieben. Hierbei wird die Herstellung der Sensorstruktur mit bekannten technologischen Verfahren erläutert. Die besagte hermetische Verkappung erfolgt mit einem separaten Kappen-Wafer aus Silizium, der mit aufwendigen Strukturierungsprozessen, wie beispielsweise KOH-Ätzen, strukturiert wird. Der Kappen-Wafer wird mit einem Glas-Lot (Seal-Glas) auf dem Substrat mit dem Sensor (Sensor-Wafer) aufgebracht. Hierfür ist um jeden Sensorchip ein breiter Bond-Rahmen notwendig, um eine ausreichende Haftung und Dichtheit der Kappe zu gewährleisten. Dies begrenzt die Anzahl der Sensor-Chips pro Sensor-Wafer erheblich. Auf Grund des großen Platzbedarfs und der aufwendigen Herstellung des Kappen-Wafers entfallen erhebliche Kosten auf die Sensor-Verkappung.

Die Patentschrift US 4,665,610, die als nächsteliegender Stand der Technik betrachtet werden kann, beschreibt ein Herstellungsverfahren eines mikromechanischen Sensors. Dieser Sensor enthält ein Diaphragma, das aus zwei Polysiliziumschichten besteht. Das Diaphragma kann durch thermische Oxidation der Polisiliziumschichten versiegelt werden (vgl. Abb. 19).

### VORTEILE DER ERFINDUNG

Das erfindungsgemäße Herstellungsverfahren mit den Merkmalen des Anspruchs 1 bzw. das mikromechanische Bauelement nach Anspruch 11 weisen folgende Vorteile auf.

Es baut auf einen bekannten OMM-Prozeß auf, der Epitaxie-Polysilizium mit mindestens 10 µm Dicke zur Bildung einer mikromechanischen Funktionsschicht schafft. Es wird keine neue permeable Schicht benötigt, sondern man verwendet an sich bekannte Prozesse. Neu ist lediglich der Schritt zur Erzeugung der Verschlußschichten, welche eine Abdicht- und Einebenungsfunktion haben.

Es ergibt sich eine Vereinfachung des OMM-Prozesses, da aufgrund der zweiten mikromechanischen Funktionsschicht, die zumindest eine Abdeckfunktion übernimmt, der Kappenwafer entfällt und die Strukturen von oben kontaktiert werden können.

Weiterhin gewinnt der Prozeß an Funktionalität, d.h. dem Designer stehen weitere mechanische und/oder elektrische Bauelemente zur Realisierung des Bauelementes Verfügung. Insbesondere können folgende Funktionselemente erstellt werden:
- eine Drucksensormembran in der zweiten mikromechanischen Funktionsschicht;
- eine Leiterbahnstruktur in der zweiten mikromechanischen Funktionsschicht, welche sich mit einer oberhalb der zweiten Verschlußschicht vorgesehenen weiteren Leiterbahnstruktur überkreuzen kann;
- sehr niederohmige Zuleitungen aus Aluminium in der oberhalb der zweiten Verschlußschicht vorgesehenen weiteren Leiterbahnstruktur;
- ein vertikaler Differentialkondensator;
- weitere Verankerungen der Strukturen der ersten mikromechanischen Funktionsschicht in der zweiten mikromechanischen Funktionsschicht.

Auch können übliche IC-Verpackungen, wie Hybrid, Kunststoff, Flip-Chip etc., verwendet werden.

In den Unteransprüchen finden sich vorteilhafte Weiterbildungen und Verbesserungen des jeweiligen Gegenstandes der Erfindung.

Gemäß einer bevorzugten Weiterbildung wird eine Opferschicht auf dem Substrat vorgesehen und die Opferschicht zum Beweglichmachen der Sensorstruktur geätzt. Bei einer vereinfachten Version kann das Substrat mit einer Opferschicht und der ersten mikromechanischen Funktionsschicht als SOI(Silicon on Insulator)-Struktur vorgesehen werden.

Gemäß einer weiteren bevorzugten Weiterbildung erfolgt ein Strukturieren der ersten mikromechanischen Funktionsschicht derart, daß sie bis zur Operschicht reichende erste Durchgänge aufweist. Weiterhin erfolgt ein Strukturieren der zweiten mikromechanischen Funktionsschicht derart, daß sie bis zur ersten Verschlußschicht reichende zweite Durchgänge aufweist, welche durch Verbindungsbereiche der ersten Verschlußschicht mit den ersten Durchgängen verbunden sind. Danach erfolgt ein Ätzen der ersten Verschlußschicht zum Entfernen der Verbindungsbereiche unter Verwendung der zweiten Durchgänge als Ätzkanäle. Schließlich erfolgt ein Ätzen der Opferschicht unter Verwendung der durch das Entfernen der Verbindungsbereiche miteinander verbundenen ersten und zweiten Durchgänge als Ätzkanäle. Dies minimiert den Aufwand für die Ätzprozesse, da die Opferschicht und die erste Verschlußschicht in einem Prozeß geätzt werden können.

Für das Entfernen der optionellerweise vorgesehenen Opferschicht werden also durch die erste und zweite mikromechanische Funktionsschicht und die dazwischenliegende erste Verschlußschicht laufende Ätzkanäle erzeugt. Dadurch kann die Dicke der zweiten mikromechanischen Funktionsschicht erhöht sein und deren Festigkeit bzw. Steifigkeit verbessert sein. Demzufolge können größere Flächen überspannt werden und die Bauelemente höherem Streß ausgesetzt werden. Beim Entfernen der Opferschicht muß man keine Rücksicht auf Leiterbahn-Aluminium o.ä. nehmen, da es erst zu einem späteren Zeitpunkt aufgebracht wird.

Gemäß einer weiteren bevorzugten Weiterbildung wird eine vergrabene Polysiliziumschicht unterhalb der ersten oder zweiten mikromechanischen Funktionsschicht vorgesehen. Ein Entfallen des vergrabenen Polysiliziums und einer darunterliegenden Isolationsschicht ist ebenfalls möglich, da weitere Verdrahtungsebenen oberhalb der Sensorstruktur verfügbar sind.

Gemäß einer weiteren bevorzugten Weiterbildung werden die erste und zweite Verschlußschicht wesentlich dünner als die erste und zweite mikromechanische Funktionsschicht gestaltet.

Gemäß einer weiteren bevorzugten Weiterbildung werden die erste und/oder zweite Verschlußschicht durch eine nicht-konforme Abscheidung derart vorgesehen, daß die ersten bzw. zweiten Durchgänge nur im oberen Bereich verpropft werden. Dies reduziert die Ätzzeit beim Opferschichtentfernen, da nur ein Teil der Durchgänge verstopft ist.

Gemäß einer weiteren bevorzugten Weiterbildung werden die ersten und/oder zweiten Durchgänge als Gräben oder Löcher gestaltet, die sich nach oben hin verengen.

Gemäß einer weiteren bevorzugten Weiterbildung werden die erste und/oder zweite mikromechanische Funktionsschicht aus einem leitenden Material, vorzugsweise Polysilizium, hergestellt.

Gemäß einer weiteren bevorzugten Weiterbildung werden die erste und/oder zweite Verschlußschicht aus einem dielektrischen Material, vorzugsweise Siliziumdioxid, hergestellt.

Gemäß einer weiteren bevorzugten Weiterbildung werden auf der zweiten Verschlußschicht eine oder mehrere Leiterbahnschichten, vorzugsweise aus Aluminium, vorgesehen.

Gemäß einer weiteren bevorzugten Weiterbildung wird in die zweite mikromechanische Funktionsschicht eine Leiterbahnstrukur integriert.

### ZEICHNUNGEN

Ausführungsbeispiele der Erfindung sind in den Zeichnungen dargestellt und in der nachfolgenden Beschreibung näher erläutert.

Es zeigen:
- Fig. 1: eine schematische Querschnittsansicht eines mikromechanischen Bauelements gemäß einer ersten Ausführungsform der vorliegenden Erfindung in einem ersten Prozeßstadium;
- Fig. 2: eine schematische Querschnittsansicht des mikromechanischen Bauelements gemäß der ersten Ausführungsform der vorliegenden Erfindung in einem zweiten Prozeßstadium;
- Fig. 3: eine schematische Querschnittsansicht des mikromechanischen Bauelements gemäß der ersten Ausführungsform der vorliegenden Erfindung in einem dritten Prozeßstadium;
- Fig. 4: eine schematische Querschnittsansicht des mikromechanischen Bauelements gemäß der ersten Ausführungsform der vorliegenden Erfindung in einem vierten Prozeßstadium; und
- Fig. 5: einen vergrößerten Ausschnitt der schematischen Querschnittsansicht des mikromechanischen Bauelements gemäß der ersten Ausführungsform der vorliegenden Erfindung nach Fig. 4.

### BESCHREIBUNG DER AUSFÜHRUNGSBEISPIELE

In den Figuren bezeichnen gleiche Bezugszeichen gleiche oder funktionsgleiche Komponenten.

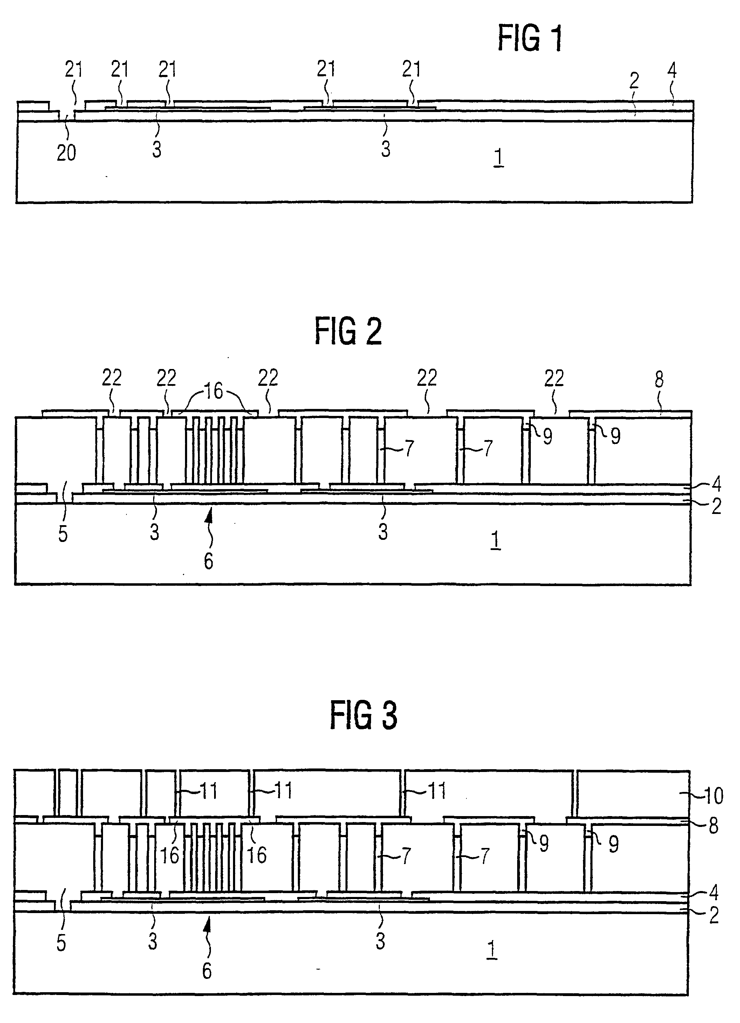

Fig. 1 zeigt eine schematische Querschnittsansicht eines mikromechanischen Bauelements gemäß einer ersten Ausführungsform der vorliegenden Erfindung in einem ersten Prozeßstadium.

In Figur 1 bezeichnet 1 einen Silizium-Substratwafer, 2 ein unteres Oxid, 3 eine vergrabene Polysiliziumschicht, 4 ein Opferoxid, 20 ein Kontaktloch im unteren Oxid 2 und 21 Kontaktlöcher im Opferoxid 4.

Zur Herstellung der in Figur 1 gezeigten Struktur erfolgt zunächst eine ganzflächige Abscheidung des unteren Oxids 2 auf dem Silizium-Substratwafer 1. In einem folgenden Schritt wird Polysilizium abgeschieden und strukturiert, um Leiterbahnen in der vergrabenen Polysiliziumschicht 3 zu erzeugen.

Darauffolgend wird das Opferoxid 4 auf die gesamte Struktur ganzflächig aufgebracht, zum Beispiel durch ein LTO (Low Temperature Oxid)-Verfahren oder durch ein TEOS (Tetraethyl-Orthosilikat)-Verfahren. Anschließend werden die Kontaktlöcher 20 und 21 an den dafür vorgesehenen Stellen mittels üblicher Phototechniken und Ätztechniken geschaffen.

Fig. 2 zeigt eine schematische Querschnittsansicht des mikromechanischen Bauelements gemäß der ersten Ausführungsform der vorliegenden Erfindung in einem zweiten Prozeßstadium.

In Figur 2 bezeichnen zusätzlich zu den bereits eingeführten Bezugzeichen 5 eine erste mikromechanische Funktionsschicht in Form einer Epitaxie-Polysiliziumschicht, 6 eine später beweglich zu machende Sensorstruktur (Kammstruktur), 7 Gräben in der ersten mikromechanischen Funktionsschicht 5, 8 ein erstes Verschlußoxid (LTO, TEOS o.ä.), 9 Pfropfen in den Gräben 7 bestehend aus dem Verschlußoxid 8, 16 Oxidverbindungsbereiche zum späteren Opferoxidätzen und 22 Kontaktlöcher im Verschlußoxid 8.

Zur Herstellung der in Figur 2 gezeigten Struktur erfolgt zunächst in bekannter Weise eine Abscheidung von Epitaxie-Polysilizium zur Bildung der ersten mikromechanischen Funktionsschicht 5, eine Strukturierung der mikromechanischen Funktionsschicht 5 zur Bildung der beweglich zu machenden Sensorstruktur 6 und der Gräben 7.

Hierauf erfolgt ein Refill-Prozess zum Verschließen der Gräben 7 mit dem Verschlußoxid 8 und anschließend optionellerweise eine Planarisierung. Obwohl nachstehend nicht explizit erwähnt, kann solch eine Planarisierung prinzipiell nach jeder ganzflächigen Schichtabscheidung vorgenommen werden.

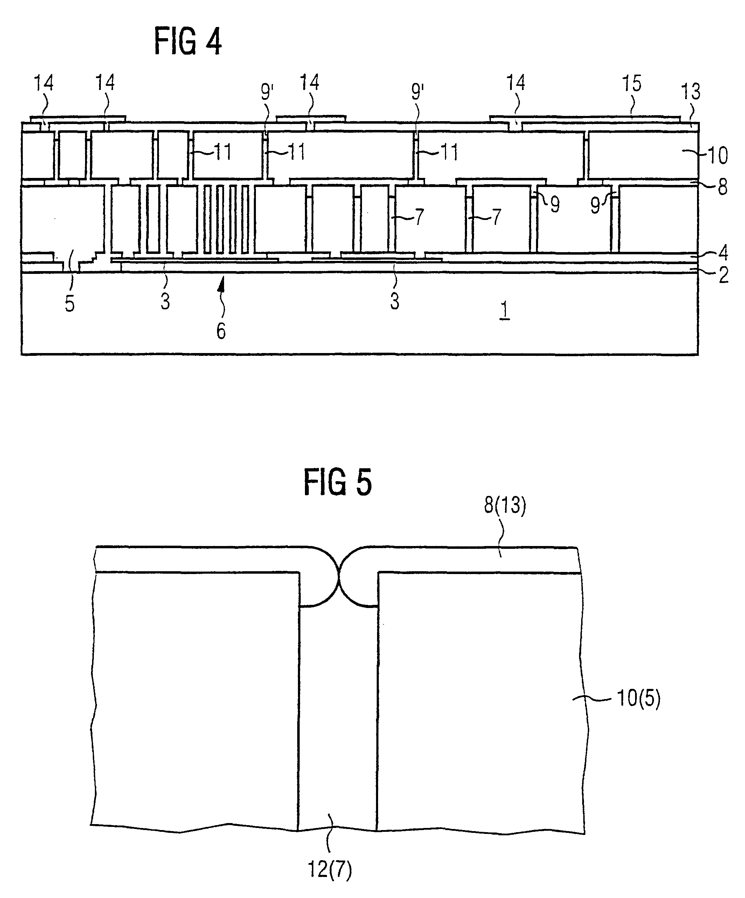

Beim gezeigten Beispiel ist der Refill nicht vollständig, sondern deckt die darunter liegende Struktur nur nach oben hin zu 100 % ab und sorgt ebenfalls für eine Abdichtung. Dies ist in Figur 5 detaillierter gezeigt.

Es folgt ein Prozess zur Bildung der Kontaktlöcher 22 durch übliche Phototechniken und Ätztechniken. Diese Kontaktlöcher 22 dienen zur Verankerung der später aufzubringenden zweiten mikromechanischen Funktionsschicht 10 (vergleiche Figur 3) und zur Eingrenzung von den Oxidverbindungsbereichen 16 zum späteren Opferoxidätzen.

Fig. 3 zeigt eine schematische Querschnittsansicht des mikromechanischen Bauelements gemäß der ersten Ausführungsform der vorliegenden Erfindung in einem dritten Prozeßstadium.

In Figur 3 bezeichnen zusätzlich zu den bereits eingeführten Bezugszeichen 10 eine zweite mikromechanische Funktionsschicht in Form einer Epitaxie-Polysiliziumschicht und 11 Gräben in der zweiten mikromechanischen Funktionsschicht 10.

Zum Aufbau der in Figur 3 gezeigten Struktur wird die zweite mikromechanische Funktionsschicht 10 analog zur ersten mikromechanischen Funktionsschicht 5 als stabile Verschlußschicht für die darunterliegende Sensorstruktur 6 abgeschieden. Neben dieser Verschlußfunktion kann die zweite mikromechanische Funktionsschicht 10 natürlich auch zur Kontaktierung, als Zuleitung, als obere Elektrode usw. für das Bauelement dienen. Es folgen eine Strukturierung dieser Schicht 10 zur Herstellung der Gräben 11, welche später zusammen mit den Gräben 9 für das Opferoxidätzen benötigt werden.

Fig. 4 zeigt eine schematische Querschnittsansicht des mikromechanischen Bauelements gemäß der ersten Ausführungsform der vorliegenden Erfindung in einem vierten Prozeßstadium.

In Figur 4 bezeichnen zusätzlich zu den bereits eingeführten Bezugszeichen 13 ein zweites Verschlußoxid (LTO, TEOS o.ä.), 14 ein Kontaktloch in dem Verschlußoxid 13, 15 eine Leiterbahnebene aus Aluminium, welche über die Kontaktlöcher 14 mit der zweiten mikromechanischen Funktionsschicht 10 verbunden ist.

Ausgehend von dem in Figur 3 gezeigten Prozeßstadium werden zum Erreichen des Prozeßstadiums nach Figur 4 folgende Schritte durchgeführt. Zunächst erfolgt ein Ätzen des Verschlußoxids 8 zum Entfernen der Oxidverbindungsbereiche 16 unter Verwendung der zweiten Gräben 11 als Ätzkanäle. Darauf erfolgt ein Ätzen der Opferschicht 4 unter Verwendung der durch das Entfernen der Verbindungsbereiche 16 miteinander verbundenen ersten und zweiten Gräben 7, 11 als Ätzkanäle. Ein langes Opferoxidätzen ist möglich, da noch kein Aluminium auf der Oberfläche vorhanden ist.

In einem darauffolgenden Prozeßschritt erfolgt ein zweiter Refill-Prozeß zur Bildung des zweiten Verschlußoxids 13, wobei diese Abscheidung ebenfalls keine konforme Abscheidung ist, sondern die Gräben 11 nur an ihrer Oberfläche verpfropft. Dies ist in Figur 5 näher illustriert. Der in der Sensorstruktur 6 eingeschlossene Innendruck bzw. die Innenatmosphäre sind abhängig von den Prozeßbedingungen beim Refill-Prozeß. Diese Parameter bestimmen z.B. die Dämpfung der Sensorstruktur.

Anschließend erfolgen eine Strukturierung des zweiten Verschlußoxids 13 zur Bildung der Kontaktlöcher 14 und eine Abscheidung und Strukturierung der Leiterbahnschicht 15 aus Aluminium.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Es können insbesondere beliebige mikromechanische Grundmaterialien, wie z.B. Germanium, verwendet werden, und nicht nur das exemplarisch angeführte Siliziumsubstrat.

Auch können beliebige Sensorstrukturen gebildet werden, und nicht nur der illustrierte Beschleunigungssensor.

Obwohl in den Figuren nicht dargestellt, können die Gräben 7 bzw. 11 nach oben verengt gestaltet sein, um die nicht-konforme Abscheidung der ersten bzw. zweiten Verschlußschicht 8, 13 zu fördern.

Es kann eine Variation der Schichtdicken der ersten und zweiten mikromechanischen Funktionsschicht 5, 10 durch den Epitaxie- und Planarisierungsprozeß in einfacher Weise vollzogen werden, da das Opferschichtätzen nicht von der Permeabilität der zweiten mikromechanischen Funktionsschicht abhängt.

Natürlich kann die Abfolge mikromechanische Funktionsschicht/Verschlußschicht mehrfach erfolgen, und man kann auch eine vergrabene Leiterbahn jeweils unter einer jeweiligen mikromechanischen Funktionsschicht oberhalb der darunter liegenden mikromechanischen Funktionsschicht vorsehen.

Schließlich können auch weitere Verdrahtungsebenen in Aluminium oder sonstigen geeigneten Metallen mit dazwischen liegendem dielektrischen aufgebracht werden.

Die optionelle Planarisierung der einzelnen Ebenen, zum Beispiel mittels chemisch-mechanischem Polieren, kann auch nur in einem einzigen Polierschritt erfolgen, vorzugsweise nur für die zweite Verschlußschicht.

## Patentansprüche

1. Verfahren zur Herstellung eines mikromechanischen Bauelementes mit den Schritten:
Bereitstellen eines Substrats (1);
Vorsehen einer ersten mikromechanischen Funktionsschicht (5) auf einer Opferschicht (4) Strukturieren der ersten mikromechanischen Funlctionsscbicut (5) derart, dass sie eine beweglich zu machende Sensorstruktur (6) aufweist;
Vorsehen und Strukturieren einer ersten Verschlussschicht (8) auf der strukturierten ersten mikromechanischen Funktionsschicht (5);
Vorsehen und Strukturieren einer zweiten mikromechanischen Funktionsschicht (10) auf der ersten Verschlussschicht (8), welche zumindest eine Abdeckfunktion aufweist und zumindest teilweise in der ersten mikromechanischen Funktionsschicht (5) verankert wird;
Beweglichmachen der Sensorstruktur (6); und
Vorsehen einer zweiten Verschlussschicht (13) auf der zweiten mikromechanischen Funktionsschicht (10), wobei die erste und zweite Verschlussschicht (8, 13) wesentlich dünner als die erste und zweite mikromechanische Funktionsschicht (5, 10) gestaltet werden.

2. Verfahren nach Anspruch 1, **gekennzeichnet durch** die Schritte:
Vorsehen einer Opferschicht (4) auf dem Substrat (1); und
Ätzen der Opferschicht (4) zum Bewegliclunachen der Sensorstruktur (6).

3. Verfahren nach Anspruch 1 oder 2, **gekennzeichnet durch** die Schritte:
Strukturieren der ersten mikromechanischen Funktionsschicht (5) derart, dass sie bis zur Opferschicht (4) reichende erste Durchgänge (7) aufweist;
Strukturieren der zweiten mikromechanischen Funktionsschicht (10) derart, dass sie bis zur ersten Verschlussschicht (8) reichende zweite Durchgänge (11) aufweist, welche **durch** Verbindungsbereiche (16) der ersten Verschlussschicht (8) mit den ersten Durchgängen (7) verbunden sind;
Ätzen der ersten Verschlussschicht (8) zum Entfernen der Verbindungsbereiche (16) unter Verwendung der zweiten Durchgänge (11) als Ätzkanäle; und
Ätzen der Opferschicht (4) unter Verwendung der **durch** das Entfernen der Verbindungsbereiche (16) miteinander verbundenen ersten und zweiten Durchgänge (7, 11) als Ätzkanäle.

4. Verfahren nach Anspruch 1, 2 oder 3, **dadurch gekennzeichnet, dass** eine vergrabene Polysiliziumschicht (3) unterhalb der ersten und zweiten mikromechanischen Funktionsschicht (5, 10) vorgesehen wird.

5. Verfahren nach einem der vorhergehenden Ansprüche, **dadurch gekennzeichnet, dass** die erste und/oder zweite Verschlussschicht (8, 13) durch eine nicht-konforme Abscheidung derart vorgesehen werden, dass die ersten bzw. zweiten Durchgänge (7, 11) nur im oberen Bereich verpfropft werden.

6. Verfahren nach einem der Ansprüche 3 bis 5, **dadurch gekennzeichnet, dass** die ersten und/oder zweiten Durchgänge (7, 11) als Gräben oder Löcher gestaltet werden, die sich nach oben hin verengen.

7. Verfahren nach einem der vorhergehenden Ansprüche, **dadurch gekennzeichnet, dass** die erste und/oder zweite mikromechanische Funktionsschicht (5, 10) aus einem leitenden Matetial, vorzugsweise Polysilizium, hergestellt werden.

8. Verfahren nach einem der vorhergehenden Ansprüche, **dadurch gekennzeichnet, dass** die erste und/oder zweite Verschlussschicht (8, 13) aus einem dielektrischen Material, vorzugsweise Siliziumdioxid, hergestellt werden.

9. Verfahren nach einem der vorhergehenden Ansprüche, **dadurch gekennzeichnet, dass** auf der zweiten Verschlussschicht (13) eine oder mehrere Leiterbahnschichten (15), vorzugsweise aus Aluminium, vorgesehen werden.

10. Verfahren nach einem der vorhergehenden Ansprüche, **dadurch gekennzeichnet, dass** in die zweite mikromechanische Funktionsschicht (10) eine Leiterbahnstruktur integriert wird.

11. Mikromechanisches Bauelement mit:
einem Substrat (1);
einer beweglichen Sensorstruktur (6) in einer über dem Substrat liegenden ersten mikromechanischen Funktionsschicht (5);
einer ersten Verschlussschicht (8) auf der ersten mikromechanischen Funktionsschicht (5), die zumindest teilweise strukturiert ist;
einer zweiten mikromechanischen Funktionsschicht (10) auf der ersten Verschlussschicht (8), welche zumindest eine Abdeckfunktion aufweist und zumindest teilweise in der ersten mikromechanischen Funktionsschicht (5) verankert ist; und
einer zweiten Verschlussschicht (13) auf der zweiten mikromechanischen Funktionsschicht (10), **dadurch gekennzeichnet, dass** die erste und zweite Verschlussschicht (8, 13) wesentlich dünner als die erste und zweite mikromechanische Funktionsschicht (5, 10) sind.

12. Mikromechanisches Bauelement nach Anspruch 11, **dadurch gekennzeichnet, dass**
die bewegliche Sensorstruktur (6) über einer auf dem Substrat (1) befindlichen Opferschicht (4) liegt; und durch zumindest teilweises Entfernen der Opferschicht (4) beweglich gemacht ist.

13. Mikromechanisches Bauelement nach Anspruch 12, **dadurch gekennzeichnet, dass** die erste mikromechanische Funktionsschicht (5) bis zur Tiefe der Opferschicht (4) reichende erste Durchgänge aufweist;
die zweite mikromechanische Funktionsschicht (10) bis zur Tiefe der ersten Verschlussschicht (8) reichende zweite Durchgänge (11) aufweist; und
die ersten und zweiten Durchgänge (7, 11) durch entfernte Verbindungsbereiche (16) der ersten Verschlussschicht (8) miteinander verbunden sind.

14. Mikromechanisches Bauelement nach Anspruch 11, 12 oder 13, **dadurch gekennzeichnet, dass** eine vergrabene Polysiliziumschicht (3) unterhalb der beweglichen Sensorstruktur (10) zwischen der Opferschicht (4) und dem Substrat (1) vorgesehen ist.

15. Mikromechanisches Bauelement nach einem der Ansprüche 11 bis 14, **dadurch gekennzeichnet, dass** die erste und/oder zweite Verschlussschicht (8, 13) Pfropfen (9, 9') zum Verschließen entsprechender erster bzw. zweiter Durchgangs (7, 11) aufweist.

16. Mikromechanisches Bauelement nach einem der Ansprüche 13 bis 15, **dadurch gekennzeichnet, dass** die ersten und/oder zweiten Durchgänge (7, 11) Gräben oder Löcher sind, die sich nach oben hin verengen.

17. Mikromechanisches Bauelement nach einem der Ansprüche 11 bis 16, **dadurch gekennzeichnet, dass** die erste und/oder zweite mikromechanische Funktionsschicht (5, 10) aus einem leitenden Material, vorzugsweise Polysilizium, hergestellt sind.

18. Mikromechanisches Bauelement nach einem der Ansprüche 11 bis 17, **dadurch gekennzeichnet, dass** die erste und/oder zweite Verschlussschicht (8, 13) aus einem dielektrischen Material, vorzugsweise Siliziumoxid, hergestellt ist.

19. Mikromechanisches Bauelement nach einem der Ansprüche 11 bis 18, **dadurch gekennzeichnet,**
**dass** auf der zweiten Verschlussschicht (13) eine oder mehrere Leiterbahnschichten (15), vorzugsweise aus Aluminium, vorgesehen sind.

20. Mikromechanisches Bauelement nach einem der Ansprüche 11 bis 19, **dadurch gekennzeichnet, dass** die zweite mikromechanische Funktionssschicht (10) eine Leiterbahnstruktur aufweist.

21. Mikromechanisches Bauelement nach einem der Ansprüche 11 bis 20, **dadurch gekennzeichnet, dass** die zweite mikromechanische Funktionsschicht (10) eine Membranstruktur aufweist.

## Claims

1. Method for producing a micromechanical component having the following steps:
provision of a substrate (1);
provision of a first micromechanical functional layer (5) on a sacrificial layer (4);
patterning of the first micromechanical functional layer (5) in such a way that it has a sensor structure (6) to be mobilized;
provision and patterning of a first closure layer (8) on the patterned first micromechanical functional layer (5);
provision and patterning of a second micromechanical functional layer (10) on the first closure layer (8), which has at least one covering function and is anchored at least partially in the first micromechanical functional layer (5);
mobilization of the sensor structure (6); and
provision of a second closure layer (13) on the second micromechanical functional layer (10), the first and second closure layers (8, 13) being made significantly thinner than the first and second micromechanical functional layers (5, 10).

2. Method according to Claim 1, **characterized by** the following steps:
provision of a sacrificial layer (4) on the substrate (1); and
etching of the sacrificial layer (4) in order to mobilize the sensor structure (6).

3. Method according to Claim 1 or 2, **characterized by** the following steps:
patterning of the first micromechanical functional layer (5) in such a way that it has first passages (7) reaching as far as the sacrificial layer (4);
patterning of the second micromechanical functional layer (10) in such a way that it has second passages (11), which reach as far as the first closure layer (8) and are connected to the first passages (7) by connecting regions (16) of the first closure layer (8);
etching of the first closure layer (8) in order to remove the connecting regions (16) using the second passages (11) as etching channels; and
etching of the sacrificial layer (4) using the first and second passages (7, 11) - connected to one another by the removal of the connecting regions (16) - as etching channels.

4. Method according to Claim 1, 2 or 3, **characterized in that** a buried polysilicon layer (3) is provided below the first and second micromechanical functional layers (5, 10).

5. Method according to one of the preceding claims, **characterized in that** the first and/or second closure layer (8, 13) are provided by means of a non-conformal deposition in such a way that the first and/or respectively second passages (7, 11) are stoppered only in the upper region.

6. Method according to one of Claims 3 to 5, **characterized in that** the first and/or second passages (7, 11) are configured as trenches or holes which narrow towards the top.

7. Method according to one of the preceding claims, **characterized in that** the first and/or the second micromechanical functional layer (5, 10) are produced from a conductive material, preferably polysilicon.

8. Method according to one of the preceding claims, **characterized in that** the first and/or the second closure layer (8, 13) are produced from a dielectric material, preferably silicon dioxide.

9. Method according to one of the preceding claims, **characterized in that** one or more interconnect layers (15), preferably made of aluminium, are provided on the second closure layer (13).

10. Method according to one of the preceding claims, **characterized in that** an interconnect structure is integrated into the second micromechanical functional layer (10).

11. Micromechanical component having:
a substrate (1);
a mobile sensor structure (6) in a first micromechanical functional layer (5) lying above the substrate;
a first closure layer (8) on the first micromechanical functional layer (5), which is at least partially patterned;
a second micromechanical functional layer (10) on the first closure layer (8), which has at least one covering function and is anchored at least partially in the first micromechanical functional layer (5; 10) and
a second closure layer (13) on the second micromechanical functional layer (10),
**characterized in that** the first and second closure layers (8, 13) are significantly thinner than the first and second micromechanical functional layers (5, 10).

12. Micromechanical component according to Claim 11, **characterized in that** the mobile sensor structure (6) lies above a sacrificial layer (4) situated on the substrate (1); and is mobilized by at least partial removal of the sacrificial layer (4).

13. Micromechanical component according to Claim 12, **characterized in that** the first micromechanical functional layer (5) has first passages reaching as far as the depth of the sacrificial layer (4);
the second micromechanical functional layer (10) has second passages (11) reaching as far as the depth of the first closure layer (8); and
the first and second passages (7, 11) are connected to one another by removed connecting regions (16) of the first closure layer (8).

14. Micromechanical component according to Claim 11, 12 or 13, **characterized in that** a buried polysilicon layer (3) is provided below the mobile sensor structure (10) between the sacrificial layer (4) and the substrate (1).

15. Micromechanical component according to one of Claims 11 to 14, **characterized in that** the first and/or second closure layer (8, 13) has stoppers (9, 9') for the closure of corresponding first and/or respectively second passages (7, 11).

16. Micromechanical component according to one of Claims 13 to 15, **characterized in that** the first and/or second passages (7, 11) are trenches or holes which narrow towards the top.

17. Micromechanical component according to one of Claims 11 to 16, **characterized in that** the first and/or second micromechanical functional layer (5, 10) are produced from a conductive material, preferably polysilicon.

18. Micromechanical component according to one of Claims 11 to 17, **characterized in that** the first and/or second closure layer (8, 13) is produced from a dielectric material, preferably silicon oxide.

19. Micromechanical component according to one of Claims 11 to 18, **characterized in that** one or more interconnect layers (15) preferably made of aluminium, are provided on the second closure layer (13).

20. Micromechanical component according to one of Claims 11 to 19, **characterized in that** the second micromechanical functional layer (10) has an interconnect structure.

21. Micromechanical component according to one of Claims 11 to 20, **characterized in that** the second micromechanical functional layer (10) has a diaphragm structure.

## Revendications

1. Procédé pour fabriquer un composant micromécanique comportant les étapes suivantes :
- préparer un substrat (1),
- prévoir une première couche fonctionnelle (5) micromécanique sur une couche sacrificielle (4),
- structurer la première couche fonctionnelle (5) micromécanique de telle sorte qu'elle présente une structure de détection (6) qu'on peut rendre mobile,
- prévoir et structurer une première couche de fermeture (8) sur la première couche fonctionnelle (5) micromécanique structurée,
- prévoir et structurer sur la première couche de fermeture (8) une deuxième couche fonctionnelle (10) micromécanique qui présente au moins une fonction de recouvrement et qui est au moins en partie ancrée dans la première couche fonctionnelle (5) micromécanique,
- rendre mobile la structure de détection (6) et
- prévoir une deuxième couche de fermeture (13) sur la deuxième couche fonctionnelle (10) micromécanique, la première et la deuxième couche de fermeture (8, 13) étant formées pour être significativement plus minces que la première et la deuxième couche fonctionnelle (5, 10) micromécanique.

2. Procédé selon la revendication 1,
**caractérisé par**
les étapes suivantes :
- prévoir une couche sacrificielle (4) sur le substrat (1) et
- corroder la couche sacrificielle (4) pour rendre la structure de détection (6) mobile.

3. Procédé selon la revendication 1 ou 2,
**caractérisé par**
les étapes suivantes :
- structurer la première couche fonctionnelle (5) micromécanique de telle sorte qu'elle présente de premiers passages (7) qui atteignent la couche sacrificielle (4),
- structurer la deuxième couche fonctionnelle (10) micromécanique de telle sorte qu'elle présente de deuxièmes passages (11) qui atteignent la première couche de fermeture (8) et qui sont liés aux premiers passages (7) par des zones de liaison (16) de la première couche de fermeture (8),
- corroder la première couche de fermeture (8) pour retirer les zones de liaison (16) en ayant recours aux deuxièmes passages (11) en tant que canaux de corrosion et
- corroder la couche sacrificielle (4) en ayant recours en tant que canaux de corrosion aux premiers et aux deuxièmes passages (7, 13) reliés les uns aux autres par le retrait des zones de liaison (16).

4. Procédé selon la revendication 1, 2 ou 3,
**caractérisé en ce qu'**
on prévoit une couche en polysilicium (3) enfouie au-dessous de la première et de la deuxième couche fonctionnelle (5, 10) micromécanique.

5. Procédé selon l'une des revendications précédentes,
**caractérisé en ce qu'**
on prévoit de former la première et/ou la deuxième couche de fermeture (8, 13) par un dépôt non conforme, de telle sorte que les premiers ou les deuxièmes passages (7, 11) ne sont bouchés que dans la zone supérieure.

6. Procédé selon l'une des revendications 3 à 5,
**caractérisé en ce que**
les premiers et/ou les deuxièmes passages (7, 11) prennent la forme de tranchées ou de trous qui se rétrécissent vers le haut.

7. Procédé selon l'une des revendications précédentes,
**caractérisé en ce que**
la première et/ou la deuxième couche fonctionnelle (5, 10) micromécanique est fabriquée en un matériau conducteur, de préférence en polysilicium.

8. Procédé selon l'une des revendications précédentes,
**caractérisé en ce que**
la première et/ou la deuxième couche de fermeture (8, 13) est fabriquée en un matériau diélectrique, de préférence en dioxyde de silicium.

9. Procédé selon l'une des revendications précédentes,
**caractérisé en ce qu'**
on prévoit sur la deuxième couche de fermeture (13) une ou plusieurs couches de pistes conductrices (15), de préférence en aluminium.

10. Procédé selon l'une des revendications précédentes,
**caractérisé en ce qu'**
on intègre une structure de pistes conductrices dans la deuxième couche fonctionnelle (10) micromécanique.

11. Composant micromécanique comportant
- un substrat (1),
- une structure de détection (6) mobile située dans une première couche fonctionnelle (5) micromécanique placée sur le substrat,
- une première couche de fermeture (8) sur la première couche fonctionnelle (5) micromécanique qui est au moins en partie structurée,
- sur la première couche de fermeture (8), une deuxième couche fonctionnelle (10) micromécanique qui présente au moins une fonction de recouvrement et qui est ancrée au moins en partie dans la première couche fonctionnelle (5) micromécanique et
- une deuxième couche de fermeture (13) sur la deuxième couche fonctionnelle (10) micromécanique,
**caractérisé en ce que**
la première et la deuxième couche de fermeture (8, 13) sont significativement plus minces que la première et la deuxième couche fonctionnelle (5, 10) micromécanique.

12. Composant micromécanique selon la revendication 11,
**caractérisé en ce que**
la structure de détection (6) mobile se trouve au-dessus d'une couche sacrificielle (4) placée sur le substrat ( 1 ) et est rendue mobile en retirant au moins en partie la couche sacrificielle (4).

13. Composant micromécanique selon la revendication 12,
**caractérisé en ce que**
la première couche fonctionnelle (5) micromécanique présente de premiers passages qui parviennent jusqu'au fond de la couche sacrificielle (4),
la deuxième couche fonctionnelle (10) micromécanique présente de deuxièmes passages (11) qui parviennent jusqu'au fond de la première couche de fermeture (8) et
les premiers et les deuxièmes passages (7, 11) sont liés les uns aux autres par des zones de liaison (16) éliminées de la première couche de fermeture (8).

14. Composant micromécanique selon la revendication 11, 12 ou 13,
**caractérisé en ce qu'**
on prévoit entre la couche sacrificielle (4) et le substrat (1) une couche en polysilicium (2) enfouie au-dessous de la structure de détection (10) mobile.

15. Composant micromécanique selon l'une des revendications 11 à 14,
**caractérisé en ce que**
la première et/ou la deuxième couche de fermeture (8, 13) présente des bouchons (9, 9') pour fermer de premiers ou de deuxièmes passages (7, 11) correspondants.

16. Composant micromécanique selon l'une des revendications 13 à 15,
**caractérisé en ce que**
les premiers ou les deuxièmes passages (7, 11) sont des tranchées ou des trous qui se rétrécissent vers le haut.

17. Composant micromécanique selon l'une des revendications 11 à 16,
**caractérisé en ce que**
la première et/ou la deuxième couche fonctionnelle (5, 10) micromécanique est fabriquée en un matériau conducteur, de préférence en polysilicium.

18. Composant micromécanique selon l'une des revendications 11 à 17,
**caractérisé en ce que**
la première et/ou la deuxième couche de fermeture (8, 13) est fabriquée en un matériau diélectrique, de préférence en oxyde de silicium.

19. Composant micromécanique selon l'une des revendications 11 à 18,
**caractérisé en ce qu'**
on prévoit sur la deuxième couche de fermeture (13) une ou plusieurs couches de pistes conductrices (15), de préférence en aluminium.

20. Composant micromécanique selon l'une des revendications 11 à 19,
**caractérisé en ce que**
la deuxième couche fonctionnelle (10) micromécanique présente une structure de pistes conductrices.

21. Composant micromécanique selon l'une des revendications 11 à 20,
**caractérisé en ce que**
la deuxième couche fonctionnelle (10) micromécanique présente une structure de membrane.
